# EUROPEAN PATENT SPECIFICATION

(11) **EP 0 293 836 B1**
(45) Date of publication and mention of the grant of the patent: **27.10.1993**
(21) Application number: 88108699.5
(22) Date of filing: 31.05.1988
(51) Int. Cl.: H01L 39/24, C30B 23/02, C30B 29/22

(54) **Method for preparing thin film of superconductor**
Methode zur Herstellung einer supraleitenden Dünnschicht
Procédé de production d'une couche mince supraconductrice

(30) Priority: 31.05.1987 JP 136938/87; 04.06.1987 JP 140610/87; 04.06.1987 JP 140612/87
(43) Date of publication of application: 07.12.1988
(73) Proprietor: SUMITOMO ELECTRIC INDUSTRIES LIMITED, Osaka-shi, Osaka 541 (JP)
(72) Inventor: Fujimori, Naoji Itami Works Sumitomo Elec. Ind., Itami-shi Hyogo-ken (JP); Harada, Keizo Itami Works Sumitomo Elec. Ind., Itami-shi Hyogo-ken (JP); Yazu, Shuji Itami Works Sumitomo Elec. Ind., Itami-shi Hyogo-ken (JP); Jodai, Tetsuji Itami Works Sumitomo Elec. Ind., Itami-shi Hyogo-ken (JP)
(74) Representative: KUHNEN, WACKER & PARTNER

(56) References cited:
- JAPANESE JOURNAL OF APPLIED PHYSICS, vol. 26, no. 5, May 1987, pages L709-L710, Tokyo, JP; H. ADACHI et al.: "Preparation and characterization of superconducting Y-Ba-Cu-O thin films"

## Description

The present invention relates to a method for preparing a Y-Ba-Cu-O thin film of superconductor according to the preamble of claim 1.

A method as indicated in the preamble of claim 1 is known, for example, from Japanese Journal of Applied Physics, Vol. 26, No. 5, May 1987, pages L709-L710. It is suggested to prepare superconducting Y-Ba-Cu-O thin films by rf-magnetron sputtering in pure argon atmosphere, and post annealing the sputtered thin films in air at 900°C for one hour and, afterwards cooling the thin film at cooling rates about 400°C/h.

From Japanese Jounal of Applied Physics, Vol. 26, No. 5, May 1987, pages L738-L740 it is known to prepare thin films of superconductor Yb-Ba-Cu-O by sputtering in an Ar and O₂ atmosphere, and heating the substrate up to 700°C during the sputter process by a focused IR lamp.

Superconduction, which is explained as phase transition of electrons, is a phenomenon by which a conductor loses all resistance to electric current under specific condition to present complete diamagnetism. Under such superconduction, electric current of high density permanently flows in a superconductor absolutely with no power loss. For example, transmission loss of about 7 %, which is currently regarded as being caused following power transmission, can be extremely reduced by applying the technique of superconduction to power transmission. Further, application to an electromagnet for generating a strong magnetic field is expected as technique of advantageously facilitating implementation of nuclear fusion reaction, which is said to require electric power in excess of generated energy for development, with MHD power generation, electric motor etc. in the field of power generation, for example.

Further expected is application to a power source for a magnetic levitation train, an electromagnetically driven ship or the like, as well as to NMR, π-meson remedy, a high-energy physical experimental apparatus etc. in the fields of instrumentation and medical care.

In addition to the aforementioned use for large apparatuses, superconductive materials are adapted to provide various types of superconducting devices. A typical example of such superconducting devices is that employing the Josephson effect, through which a quantum effect is macroscopically developed by applied current when superconductive materials are weakly joined with each other. A tunnel junction type Josephson device, which has a small energy gap between superconductive materials, is expected as a switching element of an extremely high speed with lower power consumption. Further, application of the Josephson device to a supersensitive sensor for magnetic fields, microwaves, radioactive rays or the like is also expected since the Josephson effect for electromagnetic waves or magnetic fields is developed as a correct quantum phenomenon. Further, as the degree of integration of an electronic circuit is improved, power consumption per unit area approaches the limit of cooling ability. Thus, demanded is development of a superconducting device for a very high speed computer.

In spite of various efforts, superconduction critical temperatures T_{C} of conventional superconductive materials remained below 23 K, that of Nb₃Ge, for many years. However, it was discovered at the end of last year that sintered bodies of K₂NiF₄ type oxides such as [La,Ba]₂CuO₄ and [La,Sr]₂CuO₄ superconduct at higher critical temperatures, to open the possibility of non-cryogenic superconduction. It has been observed that these substances superconduct at critical temperatures of 30 to 50 K, which are extremely higher than those of the conventional.materials. Some of the substances have superconducted at temperatures exceeding 70 K. However, such superconductive materials, being sintered bodies which may microscopically contain unreacted particles or tend to be heterogeneous in composition and structure, cannot be directly applied to electronic devices. The materials must be provided in thin film structure with finely controlled composition and structure, for application to electronic devices.

Further, it has been impossible to apply superconducting thin films heretofore presented, which have low critical current density values (J_{C}) of several hundred A/cm², to devices etc. in practice. Anticipated is manufacturing of an elongated superconducting member by evaporation of a superconductive material on a wire rod or a tape-like member of metal or the like, while evaporation technique is required for the superconductive material in such manufacturing.

An object of the present invention is to provide a method of stably manufacturing a thin film of a superconductive material which has a higher critical temperature T_{C} and practical critical current density J_{C}, as well as homogeneous composition and structure.

The method according to the present invention in accordance with claim 1 comprises a thin film forming step of employing a target prepared from an oxide containing Ba, Y and Cu in atomic ratios Cu/Y of 2.5 to 3.5 and Ba/Y of 1.8 to 2.2 and of sputtering a thin film on a substrate at a substrate temperature of 600°C to 800°C in an atmosphere having a total gas pressure of 1.33 to 6.65 Nm⁻² (1 x 10⁻² to 5 x 10⁻² Torr) and containing Ar and O₂ with an O₂ content of 5 to 80 vol.%, preferably of 5 to 50 vol.%, a heat treatment step of performing heat treatment of the thin film thus formed, and a cooling step of cooling the thin film after the heat treatment at a rate not more than 4°C/min.

In the first aspect, the substrate may be prepared by a metal, a ceramic material, an oxide, an insulator or the like. The material for the substrate is preferably selected from a group of MgO, SrTiO₃, Al₂O₃, sapphire, SiO₂, quartz, yttrium stabilized zirconia (YSZ) and ZnO. A particularly preferable material is MgO or SrTiO₃. MgO and SrTiO₃ are similar in thermal expansion coefficient to the thin film, and hence no unwanted stress is applied to the thin film to break the same in sputtering and heat treatment.

According to the second aspect of the present invention, the superconducting thin film is formed on the (100) surface of a single crystal substrate which is lattice-matched with the (100) surface of a crystal substance of Y₁Ba₂Cu₃O₇₋ₙ, where n represents a number satisfying 0 ≦ n < 1. In the second aspect, the c-axis of the crystal member forming the thin film can be oriented perpendicularly to the surface of the substrate, whereby c-axis orientation of the thin film can be improved to increase critical current density. In the second aspect, the substrate is preferably prepared by the single crystal substrate such as MgO, which have a lattice constant approximate to that of the a-axis or b-axis on the (100) surface of the crystal member of Y₁Ba₂Cu₃O₇₋ₙ.

According to the third aspect of the present invention, the superconducting thin film is formed on the (110) surface of a singlecrystal substrate which is lattice-matched with the (110) surface of the crystal substance of Y₁Ba₂Cu₃O₇₋ₙ. In the third aspect, the c-axis of the crystal member forming the thin film can be oriented parallelly to the surface of the substrate, thereby to give anisotropy in the plane direction, so that electric current of high density can flow in the depth direction of the film.

In the present invention, the distance between the target and the substrate is preferably 20 to 45 mm when the superconducting thin film is formed. The formed thin film is heat-treated preferably at 600 to 930°C, more preferably at 600 to 800°C. The time of the heat treatment is preferably 1 to 30 hours, more preferably 10 to 30 hours.

The superconducting thin film formed according to the present invention is of a Y-Ba-Cu-O oxide. Particularly preferable is a superconducting thin film which is in composition generally expressed in Y₁Ba₂Cu₃O₇₋ₙ, where n represents a number satisfying 0 ≦ n < 1. Further, such an oxide is preferably in perovskite structure or pseudo-perovskite crystal structure.

Superconductivity of the superconducting thin film obtained according to the inventive method is greatly influenced by oxygen deficiency in crystal. In order to properly control such oxygen deficiency in crystal, the heat treatment step is preferably performed in an atmosphere containing O₂.

In a preferred embodiment of the present invention, the sputtering process. is performed by magnetron sputtering. A thin film provided by magnetron sputtering is particularly preferable in crystal structure, the state of oxygen deficiency and the like, to attain excellent superconductivity. The present invention makes it possible to obtain a superconducting oxide thin film which is extremely higher in critical current density J_{C} than a conventional superconductor. Thus, the present invention is effectively used in the field of applying a superconductor to a thin film device, such as a Matisoo switching device called the Josephson device, an Anacker memory device or a superconducting quantum interferometer (SQUID), for example.

These and other objects, features, aspects and advantages of the present invention will become more apparent from the following detailed description of the present invention when taken in conjunction with the accompanying drawing.

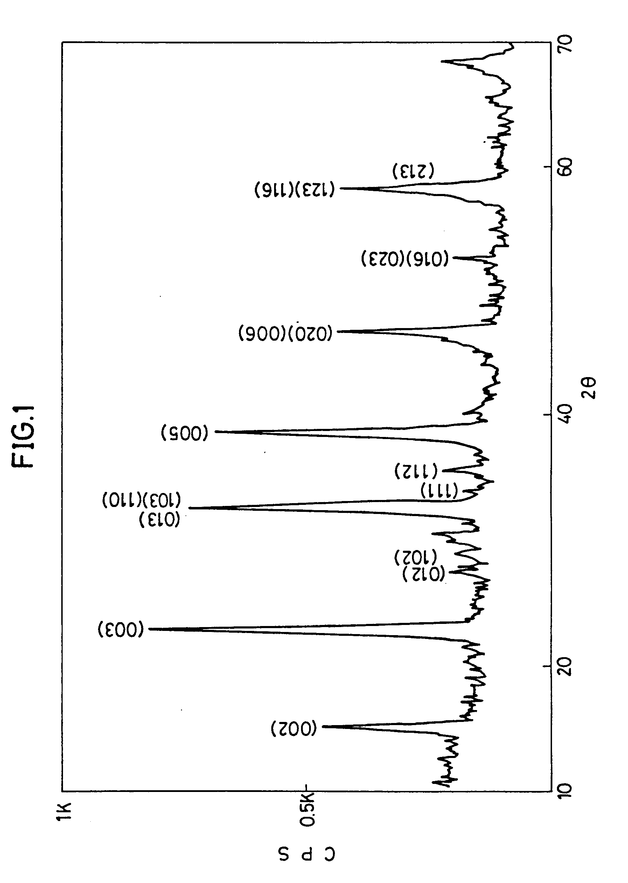

Fig. 1 illustrates an X-ray diffraction pattern of a superconducting thin film obtained by an embodiment according to the method of the present invention.

Y₂O₃, BaO and CuO were weighed to be in atomic ratios Cu/Y of 3.2 and Ba/Y of 2.15, and fired in the atmosphere at 900°C. The fired body thus obtained was pulverized into powder, which was employed as a target to form a film by high-frequency magnetron sputtering. Film forming conditions were as follows:
Total Pressure: 2.66 Nm⁻² (2 x 10⁻² Torr)
O₂/A: 0.16
Substrate: that of MgO single crystal with (100) surface employed as film forming surface
Substrate Temperature: 720°C
Thus, a thin film of 100 nm (1000 Å) in thickness was obtained. This film was heated to 700°C in an oxygen current and maintained under the said temperature for 24 hours, and thereafter cooled to the room temperature at a cooling rate of 3°C/min.

The thin film thus obtained was considered to be of Y₁Ba₂Cu₃O₇₋ₙ, which was a polycrystalline substance having c-axis orientation perpendicular to the film forming surface of the substrate. Fig. 1 shows an X-ray diffraction pattern of the thin film obtained in the aforementioned manner. This X-ray diffraction pattern was obtained through K alpha rays on Cu by employing an X-ray diffraction apparatus by Rigaku Denki.

A sample of 1 mm in width and 100 nm (1000 Å) in thickness was cut from the thin-film, to be subjected to measurement of superconductive characteristics by a four terminal method.

The results are as follows:
T_{C}: 85 K
J_{C}: 150,000 A/cm²
Consequently, it has been proved that crystal structure of a thin film can be controlled to be in c-axis orientation and its oxygen deficiency state can be properly controlled according to the present invention, to obtain a superconducting thin film of excellent superconductivity having extremely high critical current density J_{C}, in particular.

## Claims

1. A method of preparing a thin film of Y-Ba-Cu-O superconductor comprising:
a thin film forming step of employing a target prepared from an oxide containing Ba, Y and Cu in atomic ratios Cu/Y of 2.5 to 3.5 and Ba/Y of 1.8 to 2.2 and of sputtering a thin film on a substrate at a substrate temperature of 600°C to 800°C in an atmosphere having a total gas pressure of 1.33 to 6.65 Nm⁻² (1 x 10⁻² to 5 x 10⁻² Torr) and containing Ar and O₂ with an O₂ content of 5 to 80 Vol. %;
a heat treatment step of performing heat treatment of said thin film thus formed; and
a cooling step of cooling said thin film after said heat treatment at a rate not more than 4°C/min.

2. A method in accordance with claim 1, wherein said heat treatment step comprises a step of performing heat treatment at 600 to 930°C, particularly at 600 to 800°C.

3. A method in accordance with claim 1, wherein said heat treatment step comprises a step of performing heat treatment for 1 to 30 hours, particularly for 10 to 30 hours.

4. A method in accordance with claim 1, wherein said thin film forming step comprises a step of forming a thin film in an atmosphere containing Ar and O₂ with an O₂ content of 5 to 50 vol.%.

5. A method in accordance with claim 1, wherein said thin film forming step comprises a step of forming a thin film on a substrate prepared by at least one material selected from a group of MgO, SrTiO₃, Al₂O₃, sapphire, SiO₂, quartz, YSZ and ZnO.

6. A method in accordance with claim 1, wherein said thin film forming step comprises a step of forming a thin film on a substrate of MgO or SrTiO₃.

7. A method in accordance with claim 1, wherein said thin film forming step comprises a step of forming a thin film on the (100) surface of a single crystal substrate of MgO or SrTiO₃.

8. A method in accordance with claim 1, wherein said thin film forming step comprises a step of forming a thin film on the (110) surface of a single crystal substrate of MgO or SrTiO₃.

9. A method in accordance with claim 1, wherein said thin film forming step comprises a step of forming a thin film with the distance between said target and said substrate being 20 to 45 mm.

10. A method in accordance with claim 1, wherein said thin film forming step comprises a step of forming a thin film having a composition of Y₁Ba₂Cu₃O₇₋ₙ, where n represents a number satisfying 0 ≦ n < 1.

11. A method in accordance with claim 1, wherein said thin film forming step comprises a step of forming a thin film of an oxide having perovskite or pseudo-perovskite crystal structure.

12. A method in accordance with claim 1, wherein said heat treatment step comprises a step of performing heat treatment in an atmosphere containing O₂.

13. A method in accordance with claim 1, wherein said thin film forming step comprises a step of forming a thin film by magnetron sputtering.

14. A method in accordance with claim 1, wherein said thin film forming step comprises a step of forming a thin film on the (100) or (110) surface of a single crystal substrate which is lattice**-**matched with the (100) or (110), surface respectively, of a crystal substance of Y₁Ba₂Cu₃O₇₋ₙ, where n represents a number satisfying 0 ≦ n < 1.

15. A method in accordance with claim 14, wherein said thin film forming step comprises a step of forming a thin film on the (100) surface of a single crystal substrate having a lattice constant approximate to that of the a-axis or b-axis on the (100) surface of a crystal substance of Y₁Ba₂Cu₃O₇₋ₙ, where n represents a number satisfying 0 ≦ n < 1.

## Patentansprüche

1. Verfahren zur Herstellung eines Dünnfilmes eines Y-Ba-Cu-O-Supraleiters, welches aufweist:
einen Dünnfilmbildungsschritt unter Verwendung eines Targets, welches aus Sauerstoff enthaltendem Ba, Y und Cu in Atomverhältnissen Cu/Y von 2,5 bis 3,5 und Ba/Y von 1,8 bis 2,2 und Sputtern eines Dünnfilmes auf einem Substrat bei einer Substrattemperatur von 600°C bis 800°C in einer Atmosphäre mit einem Gesamt-Gasdruck von 1,33 bis 6,65 Nm⁻² (1 x 10⁻² bis 5 x 10⁻² Torr), und welche Ar und O₂ enthält mit einem O₂-Gehalt von 5 bis 80 Vol. %;
einen Wärmebehandlungsschritt zur Durchführung einer Wärmebehandlung des gebildeten Dünnfilmes; und
einen Abkühlschritt zur Abkühlung des Dünnfilmes nach der Wärmebehandlung bei einer Rate von nicht mehr als 4°C/min.

2. Verfahren nach Anspruch 1, wobei der Wärmebehandlungsschritt einen Schritt aufweist des Durchführens der Wärmebehandlung bei 600 bis 930°C, insbesondere bei 600 bis 800°C.

3. Verfahren nach Anspruch 1, wobei der Wärmebehandlungsschritt einen Schritt der Durchführung der Wärmebehandlung für 1 bis 30 Stunden, insbesondere für 10 bis 30 Stunden aufweist.

4. Verfahren nach Anspruch 1, wobei der Dünnfilmbildungsschritt einen Schritt der Bildung eines Dünnfilmes in einer Atmosphäre aufweist, die Ar und O₂ enthält mit einem O₂-Gehalt von 5 bis 50 Vol. %.

5. Verfahren nach Anspruch 1, wobei der Dünnfilmbildungsschritt einen Schritt der Bildung eines Dünnfilmes auf einem Substrat aufweist, welches durch zumindest ein Material hergestellt ist, das aus der Gruppe bestehend aus MgO, SrTio₃, Al₂O₃, Saphir, SiO₂, Quartz, YSZ und ZnO ausgewählt ist.

6. Verfahren nach Anspruch 1, wobei der Dünnfilmbildungsschritt einen Schritt der Bildung eines Dünnfilmes auf einem Substrat aus MgO oder SrTiO₃ aufweist.

7. Verfahren nach Anspruch 1, wobei der Dünnfilmbildungsschritt einen Schritt der Bildung eines Dünnfilmes auf der (100)-Oberfläche eines Einkristallsubstrates aus MgO oder SrTiO₃ aufweist.

8. Verfahren nach Anspruch 1, wobei der Dünnfilmbildungsschritt einen Schritt der Bildung eines Dünnfilmes auf der (110)-Oberfläche eines Einkristallsubstrates aus MgO oder SrTiO₃ aufweist.

9. Verfahren nach Anspruch 1, wobei der Dünnfilmbildungsschritt einen Schritt der Bildung eines Dünnfilmes mit einem Abstand zwischen dem Target und dem Substrat von 20 bis 45 mm aufweist.

10. Verfahren nach Anspruch 1, wobei der Dünnfilmbildungsschritt einen Schritt der Bildung eines Dünnfilmes mit einer Zusammensetzung von Y₁Ba₂Cu₃O₇₋ₙ aufweist, wobei n eine Zahl darstellt, die die Gleichung 0 ≦ n < 1 erfüllt.

11. Verfahren nach Anspruch 1, wobei der Dünnfilmbildungsschritt einen Schritt der Bildung eines Dünnfilmes eines Oxides mit einer Perovskit- oder Pseudo-Perovskit-Kristallstruktur aufweist.

12. Verfahren nach Anspruch 1, wobei der Wärmebehandlungsschritt einen Schritt der Durchführung einer Wärmebehandlung in einer Atmosphäre, die O₂ enthält, aufweist.

13. Verfahren nach Anspruch 1, wobei der Dünnfilmbildungsschritt einen Schritt der Bildung eines Dünnfilmes durch Magnetron-Sputtern aufweist.

14. Verfahren nach Anspruch 1, wobei der Dünnfilmbildungsschritt einen Schritt der Bildung eines Dünnfilmes auf der (100)- bzw. (110)-Oberfläche eines Einkristallsubstrates aufweist, welches gitterangepaßt ist mit der (100)- bzw. (110)-Oberfläche einer Kristallsubstanz aus Y₁Ba₂Cu₃O₇₋ₙ, wobei n eine Zahl darstellt, die die Gleichung 0 ≦ n < 1 erfüllt.

15. Verfahren nach Anspruch 14, wobei der Dünnfilmbildungsschritt einen Schritt der Bildung eines Dünnfilmes auf der (100)-Oberfläche eines Einkristallsubstrates mit einer Gitterkonstanten aufweist, die der a-Achse oder b-Achse auf der (100)-Oberfläche einer Kristallsubstanz aus Y₁Ba₂Cu₃O₇₋ₙ angenähert ist, wobei n eine Zahl darstellt, die die Gleichung 0 ≦ n < 1 erfüllt.

## Revendications

1. Procédé de préparation d'un film mince de Y-Ba-Cu-O supraconducteur comprenant:
une étape de formation de film mince utilisant une cible préparée à partir d'un oxyde contenant Ba, Y et Cu selon des rapports atomiques de Cu/Y de 2,5 à 3,5 et de Ba/Y de 1,8 à 2,2 et pulvérisant un film mince sur un substrat à une température du substrat comprise entre 600°C et 800°C dans une atmosphère dont la pression de gaz totale est comprise entre 1,33 et 6,65 Nm⁻² (1 x 10⁻² à 5 x 10⁻² torrs) et contenant Ar et O₂ avec une teneur en O₂ de 5 à 80 % en volume;
une étape de traitement thermique pour effectuer un traitement thermique dudit film mince ainsi formé; et
une étape de refroidissement pour refroidir ledit film mince après ledit traitement thermique à une vitesse ne dépassant par 4°C/min.

2. Procédé selon la revendication 1, dans lequel ladite étape de traitement thermique comprend une étape de réalisation du traitement thermique entre 600 et 930°C, et en particulier entre 600 et 800°C.

3. Procédé selon la revendication 1, dans lequel ladite étape de traitement thermique comprend une étape de réalisation du traitement thermique pendant 1 à 30 heures et en particulier pendant 10 à 30 heures.

4. Procédé selon la revendication 1, dans lequel ladite étape de formation de film mince comprend une étape de formation de film mince dans une atmosphère contenant Ar et O₂, avec une teneur en O₂ comprise entre 5 et 50 % en volume.

5. Procédé selon la revendication 1, dans lequel ladite étape de formation de film mince comprend une étape de formation d'un film mince sur un substrat préparé au moyen d'au moins une substance choisie parmi le groupe comprenant MgO, SrTiO₃, Al₂O₃, du saphir, SiO₂, du quartz, YSZ et ZnO.

6. Procédé selon la revendication 1, dans lequel ladite étape de formation de film mince comprend une étape de formation de film mince sur un substrat en MgO ou SrTiO₃.

7. Procédé selon la revendication 1, dans lequel ladite étape de formation de film mince comprend une étape de formation de film mince sur la surface (100) d'un substrat monocristallin de MgO ou SrTiO₃.

8. Procédé selon la revendication 1, dans lequel ladite étape de formation de film mince comprend une étape de formation de film mince sur la surface (110) d'un substrat monocristallin de MgO ou SrTiO₃.

9. Procédé selon la revendication 1, dans lequel ladite étape de formation de film mince comprend une étape de formation de film mince dans laquelle la distance entre ladite cible et ledit substrat est de 20 à 45 mm.

10. Procédé selon la revendication 1, dans lequel ladite étape de formation de film mince comprend une étape de formation de film mince dont la composition est Y₁Ba₂Cu₃O₇₋ₙ, où n représente un nombre satisfaisant la relation 0 ≦ n < 1.

11. Procédé selon la revendication 1, dans lequel ladite étape de formation de film mince comprend une étape de formation de film mince en un oxyde ayant la structure cristalline de perovskite ou de pseudoperovskite.

12. Procédé selon la revendication 1, dans lequel ladite étape de traitement thermique comprend une étape pour réaliser le traitement thermique dans une atmosphère contenant O₂.

13. Procédé selon la revendication 1, dans lequel ladite étape de formation de film mince comprend une étape de formation de film mince par pulvérisation magnétron.

14. Procédé selon la revendication 1, dans lequel ladite étape de formation de film mince comprend une étape de formation de film mince sur la surface (100) ou (110) d'un substrat monocristallin dont le réseau est adapté respectivement à la surface (100) ou (110) d'une substance cristalline en Y₁Ba₂Cu₃O₇₋ₙ, où n représente un nombre qui satisfait la relation 0 ≦ n < 1

15. Procédé selon la revendication 14, dans lequel ladite étape de formation de film mince comprend une étape de formation de film mince sur la surface (100) d'un substrat monocristallin présentant une constante de réseau proche de celle de l'axe a ou de l'axe b sur la surface (100) d'une substance cristalline de Y₁Ba₂Cu₃O₇₋ₙ, ou n représente un nombre satisfaisant la relation 0 ≦ n < 1.
